Europäisches Patentamt

European Patent Office

Office européen des brevets

(19)

(11) Veröffentlichungsnummer: **0 184 804 B1**

(12) # EUROPÄISCHE PATENTSCHRIFT

(45) Veröffentlichungstag der Patentschrift: **15.01.92**

(51) Int. Cl.⁵: **G03F 7/023**

(21) Anmeldenummer: **85115632.3**

(22) Anmeldetag: **09.12.85**

(54) **Lichtempfindliches Gemisch, daraus hergestelltes lichtempfindliches Aufzeichnungsmaterial und Verfahren zur Herstellung einer Flachdruckform.**

(30) Priorität: **12.12.84 DE 3445276**

(43) Veröffentlichungstag der Anmeldung:
**18.06.86 Patentblatt 86/25**

(45) Bekanntmachung des Hinweises auf die
Patenterteilung:
**15.01.92 Patentblatt 92/03**

(84) Benannte Vertragsstaaten:
**DE FR GB**

(56) Entgegenhaltungen:
**EP-A- 0 050 802**
**DE-A- 2 322 230**
**DE-A- 3 309 222**
**FR-A- 2 110 114**
**FR-A- 2 309 896**

(73) Patentinhaber: **HOECHST AKTIENGESELL-
SCHAFT**
**Postfach 80 03 20**
**W-6230 Frankfurt am Main 80(DE)**

(72) Erfinder: **Stahlhofen, Paul, Dr. Dipl.-Chem.**
**Leibnizstrasse 18B**
**W-6200 Wiesbaden(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services

**Beschreibung**

Die Erfindung betrifft ein positiv arbeitendes lichtempfindliches Gemisch, das insbesondere für die Herstellung von Flachdruckplatten geeignet ist.

Positiv arbeitende lichtempfindliche Gemische auf Basis von 1,2-Naphthochinondiaziden, die zur Herstellung von Druckplatten geeignet sind, sind seit langem bekannt. In neuerer Zeit sind für den gleichen Zweck auch Gemische aus Verbindungen, die bei Belichtung starke Säuren bilden, und säurespaltbaren Verbindungen, z. B. Acetalen und Orthocarbonsäureestern, beschrieben worden, z. B. in den DE-A 26 10 842 und 27 18 254. Diese Gemische enthalten bevorzugt ein wasserunlösliches, in wäßrigalkalischen Lösungen lösliches Bindemittel, vorzugsweise einen Novolak.

Druckformen, die durch Belichten und Entwickeln von derartigen lichtempfindlichen Materialien erhalten worden sind, liefern eine wesentlich höhere Druckauflage, wenn sie nach dem Entwickeln einige Minuten auf Temperaturen im Bereich von 200 bis 250 °C erhitzt werden. Wenn die lichtempfindlichen Schichten Novolak als Bindemittel enthalten, entsteht bei dieser Wärmebehandlung auf den bildfreien Stellen ein oleophiler Niederschlag aus Zersetzungsprodukten der Bildstellen, der nur durch eine intensive Behandlung mit alkalischen Lösungen wieder beseitigt werden kann.

Gemäß der EP-A 111 274 kann dieser Nachteil dadurch vermieden werden, daß als Bindemittel ein halogeniertes Polyvinylphenol verwendet wird. Wenn eine Druckform mit einem Bindemittel dieses Typs erhitzt bzw. eingebrannt wird, scheiden sich keine Niederschläge auf den bildfreien Stellen ab. Derartige Platten haben jedoch den Nachteil, daß ihre Bildstellen gegenüber alkalischen Lösungen, also z. b. gegen längere Einwirkung des Entwicklers oder gegen Feuchtwasser mit geringem Alkaligehalt, empfindlich sind und davon angegriffen werden. Das äußert sich zumeist in einer Reduzierung der Druckauflage.

Aus der DE-C 23 22 230 (= US-A 3 869 292) ist es bekannt, das Polyvinylphenol selbst als alkalilösliches Bindemittel einzusetzen. Es hat für bestimmte Anwendungen Vorteile gegenüber den Novolaken.

Andere alkalilösliche Bindemittel sind nur als Bestandteile negativ arbeitender lichtempfindlicher Materialien bekanntgeworden. So werden in der EP-A 48 876 Gemische aus Diazoniumsalz-Polykondensationsprodukten und Polymeren, z. B. Polyvinylacetalen, mit seitenständigen Sulfonylurethangruppen für die Herstellung von negativ arbeitenden Druckplatten beschrieben. Wie gefunden wurde, eignen sich die dort beschriebenen alkalilöslichen Polymeren nicht für positiv arbeitende Schichten, z. B. auf Basis von 1,2-Chinondiaziden, weil sie zu leicht in wäßrigem Alkali löslich sind und deshalb den Schichten eine zu geringe Entwicklerresistenz und Druckauflage verleihen.

Aus FR-A-2 110 114 sind strahlungsempfindliche Gemische aus einem Photoinitiator und einem in wäßrig-alkalischen Lösungen löslichen oder quellbaren, lichtempfindlichen Polymer bekannt, wobei das Polymer das Umsetzungsprodukt einer polymeren Substanz mit aktiven Wasserstoffatomen und einem Alkenyl- oder Cycloalkenylsulfonylisocyanat ist. Für diese negativ arbeitenden Gemische werden als polymere Substanz insbesondere Polyvinylalkohol und dessen Derivate angegeben. Für positiv arbeitende lichtempfindliche Gemische mit großer Druckauflage sind die beschriebenen Mischungen bei guten Entwicklungseigenschaften noch nicht geeignet.

Aus FR-A- 2 309 896 sind Bindemittel für strahlungsempfindliche Gemische auf Basis von 1,2-Chinondiaziden bekannt, die Umsetzungsprodukte aus Isocyanaten und Polymeren mit zur Reaktion mit Isocyanaten befähigten Gruppen darstellen. Als Isocyanate werden aliphatische und aromatische Derivate und als Polymere Phenol-Formaldehyd-Kondensate vom Novolaktyp angegeben.

Aufgabe der Erfindung war es, ein für die Herstellung von Flachdruckplatten geeignetes positiv arbeitendes lichtempfindliches Gemisch vorzuschlagen, das eine hohe Entwicklerresistenz und Druckauflage ergibt und das sich nach dem Entwickeln einbrennen läßt, ohne daß der Bildhintergrund verunreinigt wird.

Erfindungsgemäß wird ein lichtempfindliches Gemisch vorgeschlagen, das als lichtempfindliche Verbindung, deren Löslich-Keit bei Belichtung zunimmt ein 1,2-Chinondiazid oder eine lichtempfindliche Kombination von einer bei Belichtung eine starke Säure bildenden Verbindung und einer Verbindung, die mindestens eine durch Säure spaltbare C-O-C-Bindung aufweist, und als Bindemittel ein wasserunlösliches, in wäßrigem Alkali lösliches Polymeres eines Styrolderivates enthält.

Das erfindungsgemäße Gemisch ist dadurch gekennzeichnet, daß das Bindemittel Einheiten von Alkenylsulfonylaminocarbonyloxy- oder Cycloalkenylsulfonylaminocarbonyloxystyrolen enthält.

Erfindungsgemäß wird ferner ein lichtempfindliches Aufzeichnungsmaterial mit einem Schichtträger und einer lichtempfindlichen Schicht vorgeschlagen, die aus einem lichtempfindlichen Gemisch der vorstehend angegebenen Zusammensetzung besteht.

Erfindungsgemäß wird schließlich noch ein Verfahren zur Herstellung einer Flachdruckform vorgeschlagen, das darin besteht, daß man ein lichtempfindliches Aufzeichnungsmaterial der vorstehend angegebenen Beschaffenheit bildmäßig belichtet, die belichteten Bereiche der lichtempfindlichen Schicht mit einer wäßrig-alkalischen Entwicklerlösung auswäscht und die entwickelte und getrocknete Druckform 1 bis 20 Minuten auf eine Temperatur von 190 bis 250 °C erwärmt.

Die in dem erfindungsgemäßen Gemisch eingesetzten Sulfonylurethangruppen enthaltenden Styrolpolymerisate werden durch Umsetzen von Polymeren, die Hydroxystyroleinheiten enthalten, mit Sulfonylisocyanaten der Formel

$$R - SO_2 - NCO,$$

worin R ein aliphatischer oder cycloaliphatischer Rest mit mindestens einer olefinischen Doppelbindung ist, hergestellt. Der Rest R enthält im allgemeinen 2 bis 12 Kohlenstoffatome und eine olefinische Doppelbindung. Wenn R eine Alkenylgruppe ist, hat diese bevorzugt 2 bis 4 Kohlenstoffatome; als Cycloalkenylgruppen werden solche mit 5 bis 8 Kohlenstoffatomen bevorzugt. Beispiele sind Vinyl-, Propenyl-, Allyl-, 1-Butenyl-(4)-, Cyclohex-3-en-1-yl-,Cyclohex-1-en-yl- und Methyl-cyclohex-3-en-1-yl-gruppen. Besonders bevorzugt werden Propenyl- und Cyclohexenylreste.

Die Alkenylsulfonylaminocarbonyloxy- oder Cycloalkenylsulfonylaminocarbonyloxy-gruppen stehen vorzugsweise in der 4-Stellung des Styrolkerns.

Die in dem erfindungsgemäßen Gemisch enthaltenen Polymeren enthalten an die aromatischen Kohlenstoffatome, welche im Ausgangspolymeren die Hydroxygruppen getragen haben, gebunden die Gruppierung

$$- O - CONH - SO_2 - R,$$

in der das am Stickstoff stehende Wasserstoffatom durch die Carbonyl- und die Sulfonylgruppe so stark aktiviert ist, daß es mit wäßrigem Alkali als Proton abgespalten werden kann, wodurch sich die Entwickelbarkeit mit wäßrig-alkalischen Entwicklern ergibt.

Die für die Herstellung der erfindungsgemäß verwendeten Bindemittel notwendigen Sulfonylisocyanate sind in der EP-A 48 876 und der DE-C 12 97 601 beschrieben.

Die Sulfonylisocyanate werden vorteilhaft bei einer Temperatur im Bereich von 20 bis 40 °C innerhalb von 3 bis 4 Stunden in einem inerten Lösungsmittel, z. B. Dioxan oder Tetrahydrofuran, mit einem Polymeren umgesetzt, das Hydroxystyroleinheiten enthält. Diese Einheiten können außer der aromatischen Hydroxygruppe weitere Substituenten, wie niedere Alkyl- oder Alkoxygruppen oder Halogenatome enthalten. Die Reaktion wird vorzugsweise derart durchgeführt, daß alle phenolischen Gruppen der Hydroxystyroleinheiten mit dem Isocyanat umgesetzt werden. Nach beendeter Reaktion kann die klare Lösung zur Abscheidung des Umsetzungsprodukts bei Zimmertemperatur in die 10-fache Menge Wasser langsam eingetropft werden, wobei das Umsetzungsprodukt als farblose, amorphe, aber gut filtrierbare Masse ausfällt. Zweckmäßig wird ein zweites Mal mit Wasser aufgeschlämmt, abfiltriert und getrocknet.

Die Ausgangspolymeren können Homopolymerisate oder Mischpolymerisate von o-, m- oder p-Hydroxystyrolen mit anderen Vinylverbindungen wie Styrol, Maleinsäureanhydrid oder -monoestern, Acryl- oder Methacrylsäureestern sein. Durch den Anteil an Comonomeren kann ggf. der Grad der Alkalilöslichkeit gesteuert werden. Im allgemeinen sollten die Mischpolymerisate mindestens 50 Mol-% Hydroxystyroleinheiten enthalten. Obwohl Polymere mit einem mittleren Molekulargewicht (Zahlenmittel) zwischen 3000 und 20000 vorzugsweise verwendet werden, sind auch Polymere mit höherem oder niedrigerem Molekulargewicht geeignet.

Die Konzentration der Sulfonylurethangruppen enthaltenden Polystyrolderivate in dem lichtempfindlichen Gemisch kann je nach der Natur des lichtempfindlichen Systems und dessen Anwendung sehr unterschiedlich sein. Im allgemeinen liegt der Anteil zwischen 10 und 80, vorzugsweise zwischen 20 und 60 Gew.-%, bezogen auf das Gewicht der nichtflüchtigen Bestandteile des lichtempfindlichen Gemisches.

Die erfindungsgemäßen lichtempfindlichen Gemische enthalten ferner eine lichtempfindliche Verbindung oder eine lichtempfindliche Kombination von Verbindungen. Geeignet sind positiv arbeitende Verbindungen, d. h. solche, die durch Belichten löslich werden. Hierzu gehören o-Chinondiazide und Kombinationen von photolytischen Säurespendern und säurespaltbaren Verbindungen, wie Orthocarbonsäure- und Acetalverbindungen.

Das erfindungsgemäße Gemisch und Verfahren haben besondere Vorteile in Verbindung mit lichtempfindlichen Materialien auf Basis von o-Chinondiaziden, da deren Auflage durch Einbrennen eine besonders große Erhöhung erfährt. Geeignete Materialien dieser Art sind bekannt und z. B. in der DE-C 938 233, den DE-A 23 31 377, 25 47 905 und 28 28 037 beschrieben. Als o-Chinondiazide werden bevorzugt Naphthochinon-(1,2)-diazid-(2)-4- oder 5-sulfonsäureester oder -amide verwendet. Von diesen werden die

EP 0 184 804 B1

Ester, insbesondere die der 5-Sulfonsäure, besonders bevorzugt. Die Menge an o-Chinondiazidverbindungen beträgt im allgemeinen 5 bis 50, bevorzugt 10 bis 30 Gew.-%, bezogen auf die nichtflüchtigen Anteile des Gemischs.

Auch Materialien auf Basis säurespaltbarer Verbindungen lassen sich mit gutem Effekt einbrennen und bei dem erfindungsgemäßen Verfahren einsetzen. Kopiermaterialien dieser Art sind bekannt und z. B. in den US-A 3 779 778 und 4 101 323, der DE-C 27 18 254 und den DE-A 28 29 512, 28 29 511 und 29 28 636 beschrieben. Sie enthalten als säurespaltbare Verbindungen Orthocarbonsäurederivate, monomere oder polymere Acetale, Enolether oder Acyliminocarbonate. Als strahlungsempfindliche, Säure bildende Verbindungen enthalten sie vorwiegend organische Halogenverbindungen, insbesondere durch Halogenmethylgruppen substituierte s-Triazine, 2-Trichlormethyl-1,3,4-oxadiazole oder Trichlormethyl-benzoylmethylenbenzthiazoline.

Von den in der US-A 4 101 323 beschriebenen Orthocarbonsäurederivaten werden besonders die Bis-1,3-dioxan-2-yl-ether von aliphatischen Diolen verwendet.

Von den in der DE-C 27 18 254 beschriebenen Polyacetalen werden diejenigen mit aliphatischen Aldehyd- und Dioleinheiten bevorzugt.

Weitere gut geeignete Gemische sind in der DE-A 29 28 636 beschrieben. Dort werden als säurespaltbare Verbindungen polymere Orthoester mit wiederkehrenden Orthoestergruppen in der Hauptkette beschrieben. Diese Gruppen sind 2-Alkylether von 1,3-Dioxa-cycloalkanen mit 5 oder 6 Ringgliedern. Besonders bevorzugt werden Polymere mit wiederkehrenden 1,3-Dioxa-cyclohex-2-yl-alkylethereinheiten, in denen die Alkylethergruppe durch Ethersauerstoffatome unterbrochen sein kann und bevorzugt an die 5-Stellung des benachbarten Rings gebunden ist.

Der Mengenanteil der säurespaltbaren Verbindungen in dem lichtempfindlichen Gemisch liegt im allgemeinen zwischen 8 und 65, vorzugsweise zwischen 14 und 44 Gew.-%, bezogen auf die nichtflüchtigen Bestandteile des Gemischs. Die Menge der Säure bildenden Verbindung liegt zwischen 0,1 und 10, vorzugsweise zwischen 0,2 und 5 Gew.-%.

In den erfindungsgemäßen lichtempfindlichen Gemischen können zusätzlich zu den Sulfonylurethangruppen enthaltenden Polymeren noch zahlreiche andere Harze mitverwendet werden, z. B. Vinylpolymerisate wie Polyvinylacetate, Polyacrylate, Polyvinylether, Polyvinylacetale, Polyvinylpyrrolidone und die Mischpolymerisate der ihnen zugrundeliegenden Monomeren. Bevorzugt werden Novolake, besonders die höher kondensierten Kondensationsharze aus substituierten Phenolen und Formaldehyd oder Kondensationsprodukte aus Phenolderivaten und 4,4'-Bis-methoxymethyl-diphenylether. Der günstigste Anteil an diesen Harzen richtet sich nach den anwendungstechnischen Erfordernissen und dem Einfluß auf die Entwicklungsbedingungen und beträgt im allgemeinen nicht mehr als 50 Gew.-% vom Sulfonylurethangruppen enthaltenden Polymeren. In geringen Mengen kann das lichtempfindliche Gemisch für spezielle Erfordernisse wie Flexibilität, Haftung, Glanz, Färbung und Farbumschlag etc. außerdem noch Substanzen wie Polyglykole, Cellulosederivate wie Ethylcellulose, Netzmittel, Farbstoffe, Haftvermittler und feinteilige Pigmente sowie bei Bedarf UV-Absorber enthalten.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone, wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykolmonoethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren.

Als Schichtträger für Schichtdicken unter ca. 10 μm werden meist Metalle verwendet. Für Offsetdruckplatten können eingesetzt werden: walzblankes, mechanisch oder elektrochemisch aufgerauhtes und ggf. anodisiertes Aluminium, das zudem noch chemisch, z. B. mit Polyvinylphosphonsäure, Silikaten, Hexafluorozirkonaten, hydrolysiertem Tetraethylorthosilikat oder Phosphaten, vorbehandelt sein kann.

Die Beschichtung des Trägermaterials erfolgt in bekannter Weise durch Aufschleudern, Sprühen, Tauchen, Walzen, mittels Breitschlitzdüsen, Rakeln oder durch Gießer-Antrag.

Belichtet wird mit den in der Technik üblichen Lichtquellen. Auch das Bestrahlen mit Elektronen oder Laser stellt eine Möglichkeit zur Bebilderung dar.

Die zum Entwickeln der Kopiermaterialien verwendeten wäßrig-alkalischen Lösungen abgestufter Alkalität, d. h. mit einem pH, das bevorzugt zwischen 10 und 14 liegt, und die auch kleinere Mengen organischer Lösungs- oder Netzmittel enthalten können, entfernen die vom Licht getroffenen Stellen der Kopierschicht und erzeugen so ein positives Abbild der Vorlage.

Bevorzugte Anwendung finden die erfindungsgemäßen lichtempfindlichen Gemische bei der Herstellung

4

von Druckformen, insbesondere Offsetdruckformen, mit Metallen, insbesondere Aluminium, als Schichtträger.

Nach dem Entwickeln kann die Druckform in an sich bekannter Weise erhitzt werden. Die Einbrenntemperaturen können im Bereich von etwa 180 bis 250° C, vorzugsweise von 200 bis 240° C, gewählt werden, wobei normalerweise Erhitzungszeiten von 1 bis 20, bevorzugt 5 bis 10 Minuten, erforderlich sind. Wenn das Trägermaterial gegen höhere Temperaturen beständig ist, ist es auch möglich, bei höheren Temperaturen einzubrennen und dementsprechend kürzere Erhitzungszeiten zu wählen.

Das erfindungsgemäße Gemisch und das daraus hergestellte lichtempfindliche Kopiermaterial zeichnen sich dadurch aus, daß sie beim Einbrennen der fertig entwickelten Druckform praktisch keine Einbrennrückstände auf den bildfreien Bereichen des Trägers ergeben.

Das zusätzliche Aufbringen einer wasserlöslichen Schutzschicht vor dem Einbrennen oder das nachträgliche Entfernen der Rückstände durch Behandeln mit Entwickler können deshalb entfallen.

Die erfindungsgemäßen Gemische lassen sich auch zur Herstellung von Leiterplatten für gedruckte Schaltungen sowie ähnliche Erzeugnisse verwenden. Sie weisen eine hohe praktische Lichtempfindlichkeit, eine scharfe Differenzierung zwischen Bild- und Nichtbildstellen, ein hohes Auflösungsvermögen, hohe Druckauflagen, eine gute Verträglichkeit mit anderen Bestandteilen in den üblichen oben genannten Beschichtungslösungsmitteln und eine leichte, schleierfreie Entwickelbarkeit in wäßrigen, von organischen Lösungsmitteln freien Entwicklern auf.

Die Erfindung wird anhand der nachfolgenden Beispiele näher erläutert, in denen Gewichtsteile (Gt) und Volumteile (Vt) im Verhältnis von g zu cm$^3$ stehen. Prozente sind, wenn nichts anderes angegeben ist, Gewichtsprozente.

Beispiel 1

123 Gt eines bromierten Poly-p-hydroxystyrols mit einem mittleren Molekulargewicht von 8000 und einem Bromgehalt von 51,6 Gew.-% werden in 200 ml wasserfreiem Tetrahydrofuran gelöst. Hierzu läßt man unter gutem Rühren 92 Gt Propenylsulfonylisocyanat (PSI) zutropfen, wobei die Reaktionstemperatur geringfügig ansteigt. Nach Beendigung der PSI-Zugabe wird eine Stunde bei Raumtemperatur nachgerührt und anschließend die Reaktionslösung noch eine Stunde bei fortwährendem Rühren und unter Rückfluß am Sieden gehalten. Hierauf läßt man die Reaktionslösung abkühlen, gießt sie unter heftigem Rühren in möglichst dünnem Strahl in etwa 7000 Vt Eiswasser und rührt noch eine Stunde nach. Man läßt das Reaktionsprodukt absitzen, gießt die überstehende Flüssigkeit ab und saugt das Produkt ab. Nach dem Trocknen hat das polymere Reaktionsprodukt einen Schmelzbereich von 80 bis 100 ° C.

Mit einer Lösung von

| 1,80 Gt | des Veresterungsproduktes aus 1 mol 2,3,4-Trihydroxy-benzophenon und 3 mol Naphthochinon-(1,2)-diazid-(2)-5-sulfonsäurechlorid, |
| 4,00 Gt | des oben beschriebenen Bindemittels, |
| 0,15 Gt | Naphthochinon-(1,2)-diazid-(2)-4-sulfonsäurechlorid und |
| 0,07 Gt | Kristallviolett in |
| 40 Gt | Ethylenglykolmonomethylether und |
| 50 Gt | Tetrahydrofuran |

wurde eine elektrochemisch aufgerauhte und anodisierte Aluminiumplatte beschichtet.

Das so hergestellte vorsensibilisierte Material mit einem Schichtgewicht von ca. 2,5 g/m$^2$ wurde unter einer transparenten Positiv-Vorlage bildmäßig belichtet und anschliessend mit einer 0,25 %igen wäßrigen Lösung von Natriummetasilikat x 9 Wasser entwickelt. Durch die Entwicklung wurden die vom Licht getroffenen Anteile der Kopierschicht entfernt, und es blieben die unbelichteten Bildstellen auf dem Schichtträger zurück, wobei man die der Vorlage entsprechende Druckschablone erhielt. Von der so hergestellten Druckform konnten in einer Offsetdruckmaschine 100.000 einwandfreie Drucke hergestellt werden.

Ersetzt man in der Beschichtungslösung das nach Beispiel 1 hergestellte Kondensationsprodukt durch Poly-p-vinylphenol ($\overline{M}_W$ 5300), so läßt sich die damit hergestellte lichtempfindliche Druckplatte nach dem Belichten unter einer transparenten Vorlage unter sonst gleichen Bedingungen nicht mehr entwickeln, d. h. auch die vom Licht getroffenen Anteile der Kopierschicht bleiben auf dem Schichtträger zurück.

Zwecks Erhöhung der Druckauflage und Verfestigung der Druckschablone wurde die Druckform einer Wärmebehandlung unterzogen. Zu diesem Zweck wurde die getrocknete Druckform nach dem Entwickeln in einem Einbrennofen 5 Minuten auf 230° C erhitzt. Durch das Erhitzen der Druckform im Ofen trat eine Verfestigung der Druckschablone ein, und die Schicht wurde resistent gegenüber Chemikalien, z. B. Korrekturmitteln, und unlöslich in organischen Lösungsmitteln, wie Aceton, Alkoholen, Toluol oder Xylol.

Nach dem Erhitzungsvorgang wurde die Druckschablone mit fetter Farbe in Gegenwart von Wasser eingefärbt, wobei nur die Druckschablone Farbe annahm, während die bildfreien Stellen der Druckform die Farbe abstießen. In einer Offsetdruckmaschine konnten 250 000 einwandfreie Drucke hergestellt werden.

Ersetzt man im Beispiel 1 das bromierte Poly-4-(propenylsulfonylaminocarbonyloxy)-styrol durch die gleiche Menge eines Kresol-Formaldehyd-Novolaks und brennt die entwickelte Druckform unter sonst gleichen Bedingungen bei 230° C ein, so resultiert im Gegensatz zu der erfindungsgemäßen Druckplatte beim Einfärben mit fetter Farbe starker Ton an den bildfreien Stellen, der nicht mehr zu entfernen ist.

In den folgenden Beispielen werden weitere Beschichtungslösungen angegeben, wobei ähnliche Ergebnisse erhalten wurden. Wenn nicht gesondert vermerkt, entsprechen Herstellung und Verarbeitung der damit erhaltenen Druckplatten den in Beispiel 1 beschriebenen Bedingungen.

Beispiel 2

Mit einer Lösung von

| | |
|---|---|
| 1,60 Gt | des Veresterungsproduktes aus 1 mol 2,3,4-Trihydroxybenzophenon und 3 mol Naphthochinon-(1,2)-diazid-(2)-5-sulfonsäurechlorid, |
| 4,00 Gt | des in Beispiel 1 angegebenen polymeren Bindemittels, |
| 2,00 Gt | eines Kresol-Formaldehyd-Novolaks mit einem Erweichungspunkt von 105 bis 120° C, |
| 0,15 Gt | Naphthochinon-(1,2)-diazid-(2)-4-sulfonsäurechlorid und |
| 0,07 Gt | Kristallviolett in |
| 40 Gt | Ethylenglykolmonomethylether und |
| 50 Gt | Tetrahydrofuran |

wurde eine elektrochemisch aufgerauhte und anodisierte Aluminiumplatte beschichtet.

Die weitere Verarbeitung wurde, wie im Beispiel 1 beschrieben, durchgeführt, wobei man die der Positiv-Vorlage entsprechende Druckschablone erhielt.

Beispiel 3

Mit einer Lösung von

| | |
|---|---|
| 2,40 Gt | einer 50 %igen Lösung eines Polyorthoesters in Toluol, hergestellt aus 7,7-Bis-hydroxymethyl-5-oxa-nonanol-(1) und Orthoameisensäuretrimethylester, |
| 0,23 Gt | 2-(4-Ethoxy-naphth-1-yl)-4,6-bis-trichlormethyl-s-triazin, |
| 3,50 Gt | des in Beispiel 1 angegebenen Bindemittels und |
| 0,06 Gt | Kristallviolettbase in |
| 40 Gt | Ethylenglykolmonomethylether und |
| 40 Gt | Tetrahydrofuran |

wurde eine elektrochemisch aufgerauhte und anodisierte Aluminiumplatte beschichtet. Die so hergestellte Druckplatte wurde 15 Sekunden unter einer 5 kW- Metallhalogenidlampe im Abstand von 110 cm bildmäßig belichtet und anschließend mit einer 0,5 %igen wäßrigen Natriummetasilikatlösung entwickelt.

Beispiel 4

60 Gt eines Poly-p-hydroxystyrols mit einem mittleren Molekulargewicht von 10.000 und einem Schmelzbereich von 170 bis 185 ° C wurden mit 75 Gt Propenylsulfonylisocyanat wie in Beispiel 1 angegeben umgesetzt. Es wurde ein ockerfarbenes Kondensationsprodukt mit einem Schmelzbereich von 115 bis 135 ° C erhalten.

Mit einer Lösung von

| | |
|---|---|
| 1,60 Gt | des Veresterungsproduktes aus 1 mol 2,3,4-Trihydroxy-benzophenon und 3 mol Naphthochinon-(1,2)-diazid-(2)-5-sulfonsäurechlorid, |
| 6,00 Gt | des oben beschriebenen Umsetzungsprodukts, |
| 0,16 Gt | 2-(Acenaphth-5-yl)-4,6-bis-trichlormethyl-s-triazin und |
| 0,07 Gt | Kristallviolett in |
| 40 Gt | Ethylenglykolmonomethylether und |
| 50 Gt | Tetrahydrofuran |

wurde eine elektrochemisch aufgerauhte und anodisierte Aluminiumplatte beschichtet, deren Oberfläche mit einer wäßrigen Lösung von Polyvinylphosphonsäure behandelt worden war. Die erhaltene Druckplatte wurde, wie in Beispiel 1 beschrieben, weiterverarbeitet.

Beispiel 5

Mit einer Lösung von

| | |
|---|---|
| 1,50 Gt | des Veresterungsproduktes aus 1 mol 2,3,4-Trihydroxy-benzophenon und 3 mol Naphthochinon-(1,2)-diazid-(2)-5-sulfonsäurechlorid, |
| 5,00 Gt | des in Beispiel 1 angegebenen Bindemittels, |
| 0,20 Gt | Naphthochinon-(1,2)-diazid-(2)-4-sulfonsäurechlorid, |
| 0,07 Gt | Kristallviolett und |
| 1,00 Gt | eines Kondensationsprodukts, hergestellt aus 3 mol 2-Methylresorcin und 2 mol 4,4'-Bis-(methoxymethyl)-diphenylether in 1,2-Dimethoxyethan in Gegenwart von Methansulfonsäure, mit einem Schmelzbereich von 70 bis 100 °C in |
| 40 Gt | Ethylenglykolmonomethylether und |
| 50 Gt | Tetrahydrofuran |

wurde eine elektrochemisch aufgerauhte und anodisierte Aluminiumplatte beschichtet, deren Oberfläche mit einer wäßrigen Lösung von Polyvinylphosphonsäure behandelt worden war.

Die unter einer transparenten Positiv-Vorlage belichtete Druckplatte wurde mit einer 0,5 %igen wäßrigen Lösung von Natriummetasilikat x 9 $H_2O$ entwickelt. Von der erhaltenen Druckform konnten 100.000 einwandfreie Drucke hergestellt werden.

**Patentansprüche**

1.  Lichtempfindliches Gemisch, das als lichtempfindliche verbindung, deren Löslichkeit bei Belichtung zunimmt ein 1,2-Chinondiazid oder eine lichtempfindliche Kombination von einer bei Belichtung eine starke Säure bildenden Verbindung und einer Verbindung, die mindestens eine durch Säure spaltbare C-O-C-Bindung aufweist, und als Bindemittel ein wasserunlösliches, in wäßrigem Alkali lösliches Polymeres eines Styrolderivates enthält, dadurch gekennzeichnet, daß das Bindemittel Einheiten von Alkenylsulfonylaminocarbonyloxy- oder von Cycloalkenylsulfonylaminocarbonyloxy-styrolen enthält.

2.  Lichtempfindliches Gemisch nach Anspruch 1, dadurch gekennzeichnet, daß die Verbindung mit mindestens einer durch Säure spaltbaren C-O-C-Bindung mindestens eine Orthocarbonsäureestergruppe oder wiederkehrende Einheiten mit Acetalgruppen enthält.

3.  Lichtempfindliches Gemisch nach Anspruch 1, dadurch gekennzeichnet, daß die Alkenylsulfonylaminocarbonyloxy- oder Cycloalkenylsulfonylaminocarbonyloxy-gruppen in der 4-Stellung des Styrolkerns stehen.

4.  Lichtempfindliches Gemisch nach Anspruch 1, dadurch gekennzeichnet, daß es 10 bis 80 Gew.-% Bindemittel, bezogen auf nichtflüchtige Bestandteile, enthält.

5.  Lichtempfindliches Aufzeichnungsmaterial mit einem Schichtträger und einer lichtempfindlichen Schicht, aus einem Gemisch nach Anspruch 1.

6.  Verfahren zur Herstellung einer Flachdruckform, dadurch gekennzeichnet, daß man ein lichtempfindliches Aufzeichnungsmaterial gemäß Anspruch 5 bildmäßig belichtet, die belichteten Bereiche der lichtempfindlichen Schicht mit einer wäßrig-alkalischen Entwicklerlösung auswäscht und die entwickelte und getrocknete Druckform 1 bis 20 Minuten auf eine Temperatur von 180 bis 250 °C erwärmt.

**Claims**

1.  Light-sensitive mixture which contains, as the light-sensitive compound, the solubility of which increases upon exposure, a 1,2-quinone diazide or a light-sensitive combination of a compound which forms a strong acid upon exposure and a compound having at least one C-O-C bond which can be split by acid and, as the binder, a polymer of a styrene derivative which is insoluble in water and soluble in aqueous alkali, wherein the binder comprises units of alkenylsulfonylaminocarbonyloxystyrenes or of cycloalkenylsulfonylaminocarbonyloxystyrenes.

2.  A light-sensitive mixture as claimed in claim 1, wherein the compound having at least one C-O-C bond which can be split by acid comprises at least one orthocarboxylic acid ester group or recurrent units containing acetal groups.

3.  A light-sensitive mixture as claimed in claim 1, wherein the alkenylsulfonylaminocarbonyloxy groups or the cycloalkenylsulfonylaminocarbonyloxy groups are in the 4-position of the styrene nucleus.

4.  A light-sensitive mixture as claimed in claim 1, which contains from 10 to 80 % by weight of binder, relative to non-volatile constituents.

5.  A light-sensitive recording material comprising a support and a light-sensitive layer formed of a mixture as claimed in claim 1.

6.  A process for the production of a planographic printing form, wherein a light-sensitive recording material as claimed in claim 5 is exposed imagewise, the exposed areas of the light-sensitive layer are washed away with an aqueous-alkaline developer solution, and the developed and dried printing form is heated to a temperature from 180 ˚C to 250 ˚C for a period of 1 to 20 minutes.

## Revendications

1. Composition photosensible contenant en tant que composé photosensible, dont la solubilité augmente à l'insolation, un 1,2-quinonediazide ou une association photosensible d'un composé formant un acide fort lors de l'insolation, et d'un composé qui comporte au moins une liaison C-O-C pouvant être rompue par un acide, et, en tant que liant, un polymère d'un dérivé de styrène, insoluble dans l'eau, soluble dans un alcali en solution aqueuse, caractérisée en ce que le liant contient des motifs d'alcénylsulfonylaminocarbonyloxy- ou de cycloalcénylsulfonylaminocarbonyloxystyrènes.

2. Composition photosensible selon la revendication 1, caractérisée en ce que le composé comportant au moins une liaison C-O-C pouvant être rompue par un acide contient au moins un groupe ester d'acide orthocarboxylique ou des motifs répétitifs à groupes acétal.

3. Composition photosensible selon la revendication 1, caractérisée en ce que les groupes alcénylsulfonylaminocarbonyloxy ou cycloalcénylsulfonylaminocarbonyloxy se trouvent en position 4 du noyau styrénique.

4. Composition photosensible selon la revendication 1, caractérisée en ce qu'elle contient de 10 à 80 % en poids de liant, par rapport aux composants non volatils.

5. Matériau de reprographie photosensible comportant un support de couche et une couche photosensible, à base d'une composition selon la revendication 1.

6. Procédé pour la fabrication d'une forme d'impression à plat, caractérisé en ce que l'on expose selon l'image un matériau de reprographie photosensible selon la revendication 5, on élimine les zones exposées de la couche photosensible par lavage avec une solution aqueuse-alcaline de développement, et on chauffe pendant 1 à 20 minutes à une température de de 180 à 250˚C la forme d'impression développée et séchée.